# EUROPÄISCHE PATENTSCHRIFT

(11) **EP 0 243 684 B1**
(45) Veröffentlichungstag und Bekanntmachung des Hinweises auf die Patenterteilung: **26.05.1993**
(21) Anmeldenummer: 87104460.8
(22) Anmeldetag: 26.03.1987
(51) Int. Cl.: H01L 29/10, H01L 29/60, H01L 29/74, H01L 29/72, H01L 21/308, H01L 29/04

(54) **Abschaltbares Leistungshalbleiterbauelement und Verfahren zu dessen Herstellung**
Turn-off power semiconductor device and method of making the same
Elément semi-conducteur de puissance à extinction et méthode de fabrication

(30) Priorität: 30.04.1986 CH 1775/86
(43) Veröffentlichungstag der Anmeldung: 04.11.1987
(73) Patentinhaber: BBC Aktiengesellschaft Brown, Boveri & Cie., CH-5401 Baden (CH)
(72) Erfinder: Gobrecht, Jens, Dr., CH-5412 Gebenstorf (CH); Grüning, Horst, Dr., CH-5400 Baden (CH); Voboril, Jan, CH-5415 Nussbaumen (CH)

(56) Entgegenhaltungen:
- EP-A- 0 178 387
- GB-A- 2 071 912
- US-A- 4 037 245
- US-A- 4 375 124
- US-A- 4 571 815
- PATENT ABSTRACTS OF JAPAN, Band 7, Nr. 162 (E-187)[1307], 15. Juli 1983; & JP-A-58 71 656
- PATENT ABSTRACTS OF JAPAN, Band 7, Nr. 52 (E-162)[1197], 2. März 1983; & JP-A-57 201 078

## Beschreibung

Die vorliegende Erfindung betrifft ein Halbleiterbauelement, insbesondere für hohe Leistungen, gemäss dem Oberbegriff des Anspruchs 1 sowie ein Verfahren zu dessen Herstellung. Ein Halbleiterbauelement der genannten Gattung ist z.B. aus der EP-A1-0 121 068 bekannt.

Abschaltbare Leistungshalbleiterbauelemente in der Form von GTO-Thyristoren (GTO = Gate Turn Off), FCThs (FCTh = Field Controlled Thyristor) oder SIThs (SITh = Static Induction Thyristor) gewinnen in der Leistungselektronik, insbesondere bei Umrichtern oder elektrischen Antrieben, zunehmend an Bedeutung.

Neben einer hohen Strombelastbarkeit im Durchlassfall sowie hohen Sperrspannungen liegt das Hauptaugenmerk bei diesen Bauelementen auf einer guten Ansteuerbarkeit, insbesondere bezüglich des Abschaltens über die Steuerelektrode bzw. Steuerzone.

Für den Aufbau von GTO-Thyristoren und FCThs, auf welche sich die weiteren Ausführungen beschränken, ist in der eingangs zitierten Druckschrift eine stufenförmige, aus abwechselnd aufeinanderfolgenden Gate- und Kathodenfingern bestehende, sogenannte "recessed gate"-Struktur vorgeschlagen worden, bei der ausserhalb der stehenbleibenden Kathodenfinger das gesamte Halbleitersubstrat bis auf die tieferliegende Ebene des Gatekontaktes abgetragen wird. Wie in der Fig. 1 dieser Druckschrift sehr anschaulich zu sehen ist, bildet beim fertigen Bauelement (GTO oder FCTh) die tieferliegende Gateebene eine neue, durchgehende Hauptebene, aus der die stehengebliebenen Kathodenfinger nach oben hin herausragen.

Desgleichen ist aus der US-A-4 571 815 ein vertikaler FET bzw. FCT bekannt, der auf der Source- bzw. Kathodenseite eine Mehrzahl von nebeneinanderliegenden Kathodenfingern aufweist, die durch Gategräben (40 in Fig. 7) voneinander getrennt sind. Die Gategräben beschränken sich dabei nicht auf den direkten Zwischenraum zwischen den Fingern, sondern sind Teil einer tiefergelegten Gateebene, die alle Kathodenfinger vollständig umschliesst und so zu aus der Gateebene herausragenden Strukturen nach Art eines "recessed gate" macht.

Der Aufbau dieser bekannten Bauelemente mit "recessed gate"-Struktur hat zwar den Vorteil einer sehr einfachen Kontaktierbarkeit auf der Kathodenseite. Dem stehen jedoch Einschränkungen gegenüber, die sich insbesondere hinsichtlich des erreichbaren Steuerungsverhaltens, aber auch bei der Herstellung, ungünstig auswirken.

Zum Einen muss, wenn zum Erreichen einer hohen Sperrspannungsbelastbarkeit im Randbereich ausserhalb der durch die Kathodenfinger vorgegebenen Steuerzone ein Graben verwendet wird, in einem zusätzlichen Prozessschritt eine tiefe, selektive und damit vergleichsweise umständliche p-Diffusion vorgesehen werden, um die negativen Einflüsse des an die Oberfläche tretenden P-N-Uebergangs zu neutralisieren.

Zum Anderen ergeben sich durch die ausgeprägt stufige Struktur nach der Tiefätzung Probleme bei allen nachfolgenden photolithographischen Prozessen, da sich der Photolack mit sehr unterschiedlicher Dicke auf der stark strukturierten Substratoberfläche verteilt. Dies führt insbesondere bei der Aetzung der Gatemetallisierung in den Gategräben zu Problemen, so dass in der Praxis nur der Gateboden metallisiert werden kann, damit die elektrische Trennung zwischen Gate- und Kathodenkontakt mit genügender Sicherheit erreicht wird. Deshalb dürfen die Gräben eine gewisse Breite nicht unterschreiten, was seinerseits die erreichbare Dichte der Kathodenfinger in der Steuerzone beschränkt.

Aufgabe der vorliegenden Erfindung ist es nun, ein Halbleiterbauelement anzugeben, welches auf die ausgeprägt stufige Struktur auf der Kathodenseite verzichtet und dadurch zugleich eine dichtere Anordnung der Kathodenfinger und daraus resultierend ein verbessertes Ansteuerverhalten aufweist.

Die Aufgabe wird bei einem Halbleiterbauelement der eingangs genannten Art durch die Merkmale aus dem Kennzeichen des Anspruchs 1 gelöst.

Der Kern der Erfindung besteht darin, dass bei einem Halbleiterbauelement mit fein unterteilter Steuerzone, welche abwechselnd aufeinanderfolgende Gate- und Kathodenfinger umfasst, nicht mehr das gesamte Halbleitersubstrat um die Kathodenfinger herum bis auf das tieferliegende Niveau der Gateebene durch einen Tiefätzprozess abgetragen wird, sondern dass aus dem Halbleitersubstrat nur noch die Gategräben zwischen den Kathodenfingern in Form schmaler, tiefer Schlitze herausgeätzt werden, die ursprüngliche Oberfläche des Halbleitersubstrats im übrigen Gebiet, insbesondere in den Randbereichen um die Steuerzone herum, jedoch erhalten bleibt.

Das Halbleiterbauelement nach der Erfindung hat also nicht länger eine stufenförmig strukturierte, kathodenseitige Oberfläche, sondern im wesentlichen (bis auf die Gategraben-Schlitze) eine planare Oberfläche.

Durch diese Planarität lassen sich die erforderlichen, nachfolgenden photolithographischen Prozesse mit grösserer Feinheit durchführen, was zu schmaleren Gategräben, einer grösseren Kathodenfinger-Dichte und damit zu einer besseren Ausnutzung der Substrat- bzw. Waferfläche führt.

Da das Bauelement im Randbereich planar ist, können ohne Probleme alle bekannten Verfahren zur Erzeugung eines sperrspannungsfesten Randabschlusses (Graben, Guard-Ringe, elektrische Feldplatten usw.) angewandt werden, wodurch in vielen Fällen die erwähnte zusätzliche, tiefe p-Diffusion entfallen kann.

Ein weiterer Vorteil besteht darin, dass wegen der fehlenden grossflächigen Abtragung des Halbleitersubstrats die Bruchgefahr vermindert ist und daher dünneres Ausgangsmaterial verwendet werden kann, was sich zugleich günstig auf den Durchlasswiderstand (R_{ON}) auswirkt.

Weiterhin kann bei der Herstellung eines erfindungsgemässen Halbleiterbauelements besonders vorteilhaft eine anisotrope chemische Nassätztechnik eingesetzt werden, mit der sich besonders tiefe Gräben und damit ein sehr günstiges Verhältnis von Höhe zu Breite der Kathodenfinger erzielen lassen.

Schliesslich steht aufgrund der Planarität der Randbereich des Halbleitersubstrats ausserhalb der eigentlichen Steuerzone zur Implementierung weiterer Strukturen, insbesondere in Form einer MOS-Logik oder einer geeigneten MOS-Ansteuerungselektronik, zur Verfügung.

Das erfindungsgemässe Herstellungsverfahren gemäss Anspruch 7 umfasst neben weiteren Schritten die maskierte Einbringung der n⁺-dotierten Kathodenbereiche in das Halbleitersubstrat mit der nachfolgenden, wiederum maskierten, anisotropen Tiefätzung der Gategräben.

Ausführungsbeispiele der Erfindung ergeben sich aus den Unteransprüchen.

Die Erfindung soll nun nachfolgend im Zusammenhang mit der Zeichnung anhand von Ausführungsbeispielen näher erläutert wreden.

Es zeigen:
- Fig. 1: die ausschnittsweise Wiedergabe des Querschnitts durch ein Halbleiterbauelement nach dem Stand der Technik;
- Fig. 2: einen mit Fig. 1 vergleichbaren Querschnitt durch ein Bauelement gemäss einem Ausführungsbeispiel der Erfindung;
- Fig. 3: die Draufsicht auf ein Bauelement nach Fig. 2 im Ausschnitt;
- Fig. 4: den Schnitt durch einen Gategraben entlang der Linie B-B in Fig. 3;
- Fig. 5A-D: verschiedene Stadien bei der Herstellung eines Bauelements nach der Erfindung;
- Fig. 6A: die kathodenseitige Topologie eines Bauelements nach dem Stand der Technik in perspektivischer Darstellung;
- Fig. 6B: die Fig. 6A vergleichbare Topologie eines Bauelements nach der Erfindung.

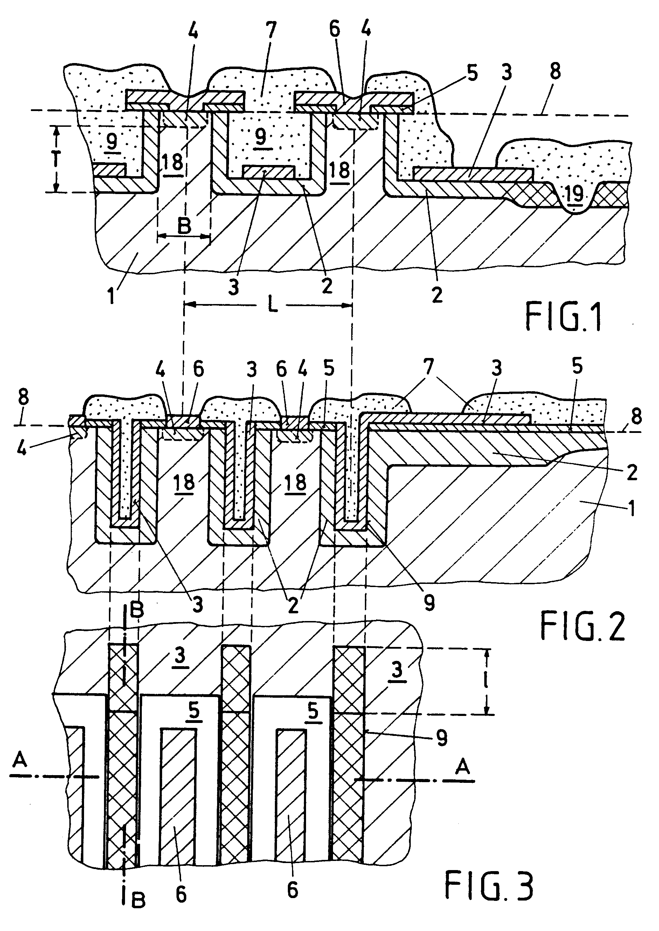

In Fig. 1 ist für ein herkömmliches Halbleiterbauelement, wie es aus der EP-A1-0 121 068 bekannt ist, in einem auf die kathodenseitige Struktur beschränkten Ausschnitt der Aufbau im Querschnitt wiedergegeben. Zur Erläuterung ist hierbei der Fall des Feldgesteuerten Thyristors (FCTh) ausgewählt worden. Die nachfolgenden Ausführungen gelten jedoch in gleicher Weise für einen GTO-Thyristor mit seiner etwas anderen Schichtenfolge im Halbleitersubstrat.

Das bekannte Halbleiterbauelement der Fig. 1 besteht im wesentlichen aus einem Halbleitersubstrat 1, meist in Form einer dünnen Scheibe, welches die für das jeweilige Bauelement charakteristische Folge von unterschiedlich dotierten Schichten umfasst. Dazu gehören im vorliegenden Fall auf der Anodenseite ein nicht dargestellter p-dotierter Anodenbereich, über dem ein n⁻-dotierter Kanalbereich (beim FCTh) angeordnet ist, der sich bis zur Kathodenseite hin erstreckt, und im Ausschnitt der Fig. 1 im wesentlichen das Halbleitersubstrat 1 ausmacht.

Das Halbleitersubstrat 1 bzw. der n⁻-dotierte Kanalbereich laufen nach oben, d.h. zur Kathodenseite hin, in einer Mehrzahl von erhabenen Kathodenfingern 18 aus, in deren Oberseiten n⁺-dotierte Kathodenbereiche 4 eindiffundiert sind.

Die Kathodenbereiche 4 sind durch metallische Kathodenkontakte 6 kontaktiert, welche ausserhalb der Kathodenbereiche 4 durch entsprechend gestaltete Isolierschichten 5 von den darunterliegenden Gebieten der Kathodenfinger 18 elektrisch isoliert sind.

Die einzelnen Kathodenfinger 18 sind durch Gräben voneinander getrennt, die innerhalb des Halbleitersubstrats 1 von p-dotierten Gatebereichen 2 umgeben sind. Die Gatebereiche 2 bilden zusammen mit der angrenzenden n⁻-dotierten Kanalschicht P-N-Uebergänge, deren Raumladungszonen sich bei geeigneter Vorspannung in die in den Kathodenfingern 18 vorhandenen Kanalgebiete ausdehnen und den dortigen Stromfluss einschnüren und schliesslich vollends unterbrechen.

Zum Anlegen der Vorspannung sind auf den Böden der Gräben metallische Gatekontakte 3 vorgesehen. Die Gräben sind weiterhin üblicherweise mit einer Passivierungsschicht 7 aufgefüllt, die sogar teilweise die Kathodenfinger 18 überdeckt, andere Gebiete der Kathodenkontakte 6 jedoch freilässt, um einen elektrischen Kathodenanschluss nach aussen hin zu ermöglichen.

Die Kathodenfinger 18 mit den dazwischen liegenden Gategräben 9 und den in diesen angeordneten Gatekontakten 3 bilden zusammen die Steuerzone des bekannten Bauelements. Für das Ansteuerungsverhalten des Bauelements und für die Ausnutzung der Substratfläche ist nun wichtig, welchen Fingerabstand L die Kathodenfinger 18 voneinander haben, und wie gross die in Fig. 1 eingezeichneten Abmessungen der Kanäle in den Kathodenfingern 18, nämlich ihre Tiefe T und ihre Breite B bzw. das Verhältnis zwischen beiden Grössen sind. Der Fingerabstand L wird dabei wesentlich durch die verhältnismässig grosse Breite der Gategräben mitbestimmt, die sich deshalb ergibt, weil die Gatekontakte 3 und die Kathodenkontakte 6 in einem einzigen Prozessschritt aufgebracht werden und die Gatekontakte 3 auf den Grabenböden eine genügend grosse Ausdehnung haben müssen, um einen ausreichend grossen Steuerstrom tragen zu können.

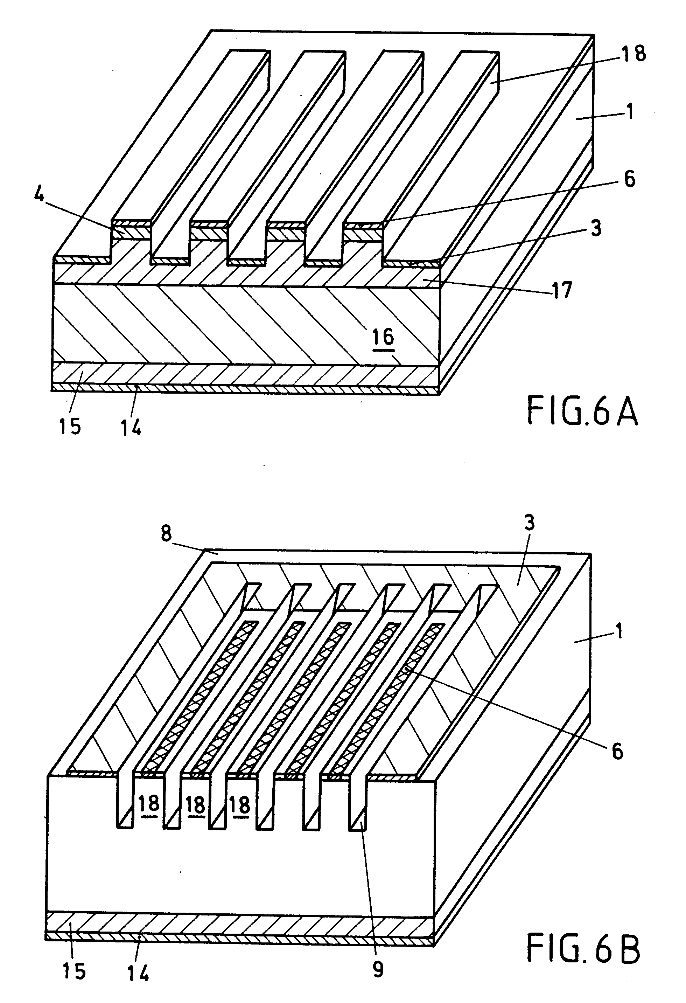

Wie aus der Fig. 1, insbesondere an dem auf der rechten Seite der Figur dargestellten Randbereich, deutlich zu erkennen ist, wird bei dem bekannten Bauelement durch den Tiefätzprozess das Halbleitersubstrat 1, ausgenommen die Kathodenfinger 18, von der ursprünglichen Substratoberfläche 8 her bis auf die Gatebene hinunter abgetragen (siehe auch die perspektivische Ansicht in Fig. 6A).

Der aus dem p-dotierten Gatebereich 2 und dem n⁻-dotierten Kanalgebiet gebildete P-N-Uebergang tritt im Randbereich seitlich an die Oberfläche. Dieser Oberflächendurchtritt hat üblicherweise eine Herabsetzung der maximalen Sperrspannung am P-N-Uebergang zur Folge, die mit geeigneten Massnahmen beseitigt werden muss. Beim bekannten Bauelement der Fig. 1 umfassen diese Massnahmen eine tiefe selektive p-Diffusion im Randbereich (in Fig. 1 kreuzschraffiert dargestellt) und einen am Rand herumgelegten, bis in das Kanalgebiet hineinreichenden Randgraben 19. Nachteilig ist hier nun, dass die tiefe selektive p-Diffusion im Randbereich nicht zusammen mit der Diffusion der p-dotierten Gatebereiche 2 vorgenommen werden kann, sondern einen separaten Prozessschritt erfordert.

Zum Vergleich mit dem bekannten Bauelement der Fig. 1 ist in Fig. 2 der entsprechende Ausschnitt aus dem Querschnitt durch ein Halbleiterbauelement nach der Erfindung wiedergegeben. Auch hier sind kathodenseitig einzelne Kathodenfinger 18 vorgesehen, welche durch Gategräben 9 voneinander getrennt sind. Auch hier erstrecken sich um die Gategräben 9 herum im Halbleitersubstrat 1 (n⁻-dotiertes Kanalgebiet beim FCTh, p-dotierte p-Basisschicht beim GTO) die p-dotierten Gatebereiche 2, die durch metallische Gatekontakte 3 kontaktiert sind.

Abgesehen von diesen Gemeinsamkeiten treten jedoch die Unterschiede zu einem herkömmlichen Bauelement nach Fig. 1 deutlich zutage: Aufgrund des andersartigen Herstellungsweges sind die Gategräben 9 als schmale, tiefe Schlitze ausgeführt. Dies hat zur Folge, dass bei gleichbleibenden Abmessungen der Kathodenfinger 18 in Querrichtung mehr Finger pro Längeneinheit auf dem Substrat angeordnet werden können. Legt man im Vergleich der Fig. 1 und 2 den Fingerabstand L aus Fig. 1 zugrunde, können im Beispiel der Fig. 2 auf dieser Länge 1,5 Finger untergebracht werden.

Die erfindungsgemässe Ausführung der Gategräben 9 als tiefe schmale Schlitze bedingt zum einen eine spezielle Aetztechnik (bevorzugt wird hierbei ein kristallrichtungsselektives, chemisches Nassätzverfahren angewendet), zum Anderen eine geänderte Technologie der Gatemetallisierung, bei der nicht nur die Böden, sondern auch die Seitenwände der Gategräben 9 mit dem Gatekontakt 3 bedeckt werden, um entsprechende Gateströme zu ermöglichen.

Der andere Herstellungsweg für ein Bauelement nach der Erfindung führt auch zu einer geänderten Konfiguration auf der Oberseite der Kathodenfinger 18, die sich im wesentlichen in schmalen Kathodenkontakten 6 und nicht überhängenden Isolierschichten 5 ausdrückt.

Die unterschiedliche Konfiguration der Isolierschichten 5 beim herkömmlichen (Fig. 1) und beim neuen (Fig. 2) Bauelement bringt für das neue Bauelement einen weiteren Vorteil: Bei der herkömmlichen Ausführung sind die Gatekontakte 3 zwar nur auf den Grabenböden aufgebracht, aber die ganzen Grabenwände liegen auf dem Gate-Potential. Die Isolierstrecke zwischen Gatepotential und Kathodenkontakten 6 besteht daher nur aus den überhängenden Bereichen der Isolierschichten 5 (etwa 2-3 µm).

Beim neuartigen Bauelement gemäss Fig. 2 steht dagegen die ganze Breite der Isolierschichten 5 (etwa 10 µm) als Isolierstrecke zur Verfügung. Darüber hinaus sind die Isolierschichten 5 nach oben hin sichtbar und damit während der Herstellung besser optisch zu kontrollieren.

Ganz wesentlich ist jedoch ein weiterer auffälliger Unterschied zum herkömmlichen Bauelement: Bis auf die Gategräben 9 selbst bleibt die ursprüngliche Substratoberfläche 8 des Halbleitersubstrats 1 unter den darüberliegenden zusätzlichen Schichten 5, 6, 3 und 7 erhalten, das Bauelement nach der Erfindung ist also weitgehend planar. Besonders deutlich wird die begrenzte Ausdehnung der Gategräben 9 in der Draufsicht auf die kathodenseitige Oberfläche, die in Fig. 3 dargestellt ist. Zwischen den Kathodenfingern, deren Ausdehnung weitgehend mit der Fläche der Isolierschichten 5 und der Kathodenkontakte 6 übereinstimmt, sind die metallisierten Gategräben 9 angeordnet, die in ihrer Länge nur wenig über die Bereiche derKathodenfinger hinausragen. Die Passivierungsschicht 7 aus Fig. 2 ist in der Darstellung der Fig. 3 selbstverständlich nicht eingezeichnet, um ein eindeutiges Bild von den lateralen Abmessungen der einzelnen Gebiete zu erhalten.

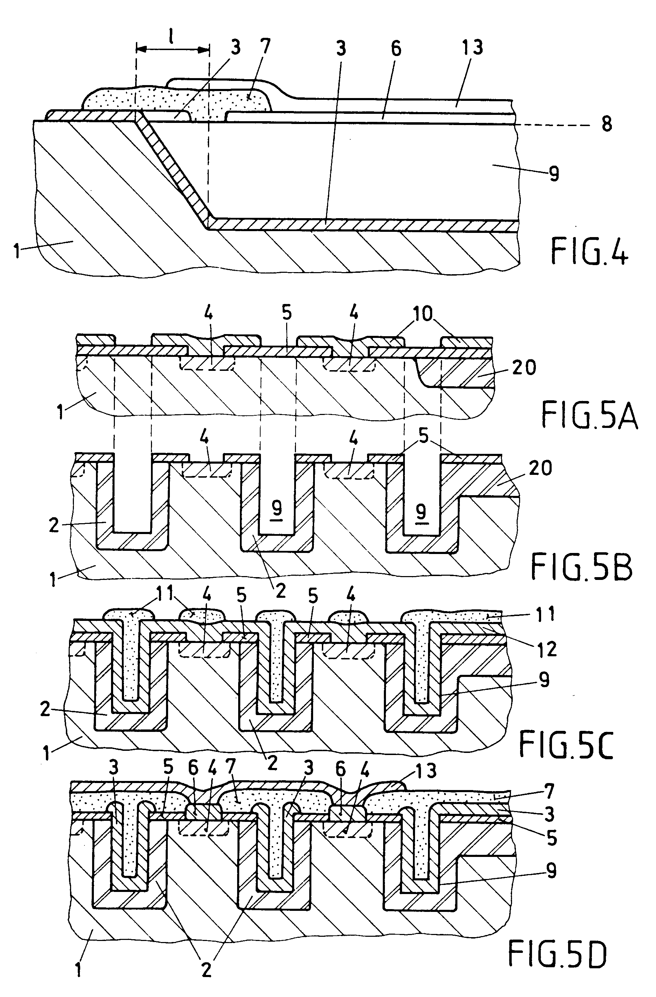

Die Fig. 2 zeigt im übrigen einen Schnitt entlang der Linie A-A in Fig. 3. Die dazu senkrechte Schnittlinie B-B bezieht sich auf die nachfolgend erläuterte Darstellung der Fig. 4.

Diese Fig. 4 zeigt einen Querschnitt entlang der Linie B-B aus Fig. 3 durch einen der Gategräben 9. Zu erkennen sind unten das Halbleitersubstrat 1 mit dem eingelassenen Gategraben 9, der den Blick auf die Seitenwand des Grabens bzw. des benachbarten Kathodenfingers freigibt, dessen Längsausdehnung durch den aufliegenden Kathodenkontakt 6 angedeutet ist.

Der Gategraben hat zwischen den Kathodenfingern einen ebenen Grabenboden, der am Grabenende auf einer Auslauflänge l (die auch in Fig. 3 eingezeichnet ist) schräg nach oben zur Substratoberfläche 8 aufsteigt. Diese Schräge am Grabenende entsteht, wenn die Gategräben 9 gemäss einer bevorzugten Methode richtungsselektiv, nasschemisch aus einem Si-Halbleitersubstrat mit bestimmter Kristallorientierung (Oberfläche in 110-Richtung; Gräben entlang 111-Richtung) herausgeätzt werden.

Neben der aus den Fig. 1 und 2 bereits bekannten Passivierungsschicht 7 ist in Fig. 4 zusätzlich eine Metallisierungsschicht 13 zu sehen, welche teilweise die Passivierungsschicht 7 und teilweise die Kathodenkontakte 6 überdeckt und zur kathodenseitigen Kontaktierung des fertigen Bauelements dient.

Neben der besonderen "quasi-planaren" Topologie sind für das neuartige Bauelement vor allem auch die geometrischen Abmessungen der Einzelelemente (Gategraben, Kathodenfinger, Kanal) in der Steuerzone von Bedeutung. Hierbei sind die beiden Fälle zu unterscheiden, dass das Bauelement die Struktur eines GTO-Thyristors oder eines FCTh haben kann.

Beim feldgesteuerten Thyristor FCTh spielt für das Ansteuerungsverhalten vor allem der sogenannte "aspect ratio", d.h. das Verhältnis von Tiefe T zu Breite B der Kanäle in den Kathodenfingern 18 (beide Grössen sind in der Fig. 1 eingezeichnet), eine grosse Rolle. Dieses Verhältnis liegt gemäss einem Ausführungsbeispiel der Erfindung in einem Bereich von T/B = 0,5 bis T/B = 10. Besonders bevorzugt ist ein Verhältnis zwischen 1 und 2. Die Kathodenfinger 18 sind hierbei selbst zwischen 5 und 500 µm breit, wobei einer Breite von 20 µm der Vorzug gegeben wird. Die Gategräben 9 schliesslich weisen, genau wie die Kathodenfinger 18, einen Breitenbereich von 5 bis 500 µm auf. Bevorzugt werden die Gategräben jedoch als nur etwa 10 µm breite Schlitze ausgeführt.

Beim GTO-Thyristor kommt dem genannten "aspect ratio" eine wesentlich geringere Bedeutung zu, weil hier die Abschaltung nicht über die Einschnürung eines Kanals erfolgt. Für den GTO sollten die Abmessungen der Gategräben 9 derart sein, dass ihre Tiefe grösser als 5 µm, jedoch kleiner als die Tiefe der in das Halbleitersubstrat eingelassenen p-Basisschicht, ist. Bevorzugt liegt die Tiefe bei etwa 20 µm. Die Breite der Gategräben liegt wiederum in einem Bereich zwischen 5 µm und 500 µm, vorzugsweise bei etwa 10 um. Die Kathodenfinger 18 sind, wie beim FCTh, zwischen 5 µm und 500 µm, insbesondere etwa 50 µm breit.

Für die Dotierungskonzentrationen in den einzelnen Halbleiterschichten des neuen Bauelements kann auf die aus der EP-0 121 068 gemachten Angaben zurückgegriffen werden.

Wie bereits erwähnt wurde, kommt dem Verfahren zur Herstellung des neuartigen Bauelements wegen der besonderen Ausgestaltung der Gategräben eine wesentliche Bedeutung zu. Einzelne Stadien des eine Vielzahl von Prozessschritten umfassenden Herstellungsverfahrens sind in den nachfolgend erläuterten Fig. 5A-5D in Querschnittsbildern durch das bearbeitete Halbleitersubstrat dargestellt.

Ausgegangen wird von einer planaren Halbleitersubstratscheibe, deren innere Folge unterschiedlich dotierter Schichten durch vorangegangene Diffusions- oder Implantationsschritte bereits erzeugt worden ist. Insbesondere gilt dies für eine eventuelle p-dotierte Randschicht 20 (Fig. 5A), die durch eine tiefe Diffusion in das Substrat eingebracht wird, bevor weitere Strukturierungsschritte auf der kathodenseitigen Substratoberfläche unternommen werden, und die für den Fall der Verwendung eines Grabens als Randabschluss des P-N-Uebergangs wichtig ist.

Auf das so vorbereitete Substrat wird zunächst eine durchgehende Maskenschicht, vorzugsweise aus SiO₂, aufgebracht. Diese Maskenschicht wird dann selektiv in den Gebieten der späteren Kathodenkontakte durch Aetzen entfernt, so dass eine Maske entsteht. Durch die ausgeätzten Fenster dieser Maske werden dann, durch Diffusion oder Implantation, die n⁺-dotierten Kathodenbereiche 4 (Fig. 5A) in das Halbleitersubstrat 1 eingebracht.

Daran anschliessend werden die Maskenschicht und ihre Fenster bis auf die Gebiete der späteren Gategräben mit einer ätzresistenten Maske abgedeckt. Das so erreichte Zwischenstadium des Halbleitersubstrats ist in Fig. 5A ausschnittsweise wiedergegeben. Zu sehen ist das Halbleitersubstrat 1 mit der randseitig angeordneten, p-dotierten Randschicht 20, mit den eindiffundierten, n⁺-dotierten Kathodenbereichen 4, mit der für diese Diffusion verwendeten SiO₂-Maskenschicht, die hier bereits wegen ihrer späteren Funktion als Isolierschicht 5 bezeichnet ist, und die strukturierte Aetzmaske 10, welche Fenster für die nachfolgende Tiefätzung der Gategräben aufweist.

Die anisotrope Tiefätzung der Gategräben kann beispielsweise, ohne Rücksicht auf die Kristallorientierung des einkristallinen Halbleitersubstrats, in bekannter Weise durch reaktives Ionenätzen (RIE = Reactive Ion Etching) realisiert werden. Die erwähnte ätzresistente Maske hat dann vorzugsweise die Form einer Al-Schicht. Bevorzugt wird jedoch ein kristallrichtungsselektives chemisches Nassätzverfahren angewendet, wie es aus dem Artikel von D.L. Kendall, Appl. Phys. Lett. 26, No. 4 (1975), S. 195 f., bekannt ist. In diesem Fall besteht die ätzresistente Maske zweckmässigerweise aus SiO₂, das durch erneute Oxidation gebildet oder mittels eines bekannten CVD (Chemical Vapor Deposition)-Verfahrens abgeschieden wird.

Für dieses nasschemische Aetzverfahren wird von einem einkristallinen Si-Halbleitersubstrat ausgegangen, welches mit der dem Aetzangriff ausgesetzten Oberfläche (hier der kathodenseitigen Oberfläche) in 110-Kristallrichtung orientiert ist. Werden nun weiterhin die zu ätzenden Gategräben mit ihrer Längsrichtung parallel zur 111-Kristallrichtung ausgerichtet, lassen sich extrem schmale und tiefe schlitzförmige Gräben ausheben, wie sie beim erfindungsgemässen Bauelement mit besonderem Vorteil als Gategräben eingesetzt werden können.

Als günstig hat sich die Aetzung mit einer 44 %-igen KOH-Lösung bei einer Temperatur von etwa 80°C erwiesen, bei der Aetzraten von ungefähr 2 µm/min erreicht werden.

Nach der erfolgten nasschemischen Aetzung der Gategräben bzw. -schlitze durch die Fenster der Aetzmaske 10 werden, z.B. durch maskierte Bor-Diffusion, von den Gategräben 9 aus die p-dotierten Gatebereiche 2 in das Halbleitersubstrat 1 eingebracht (Fig. 5B). Im Randbereich gehen die Gatebereiche 2 in die bereits vorhandene, ebenfalls p-dotierte Randschicht 20 über.

Als nächster Schritt schliesst sich eine ganzflächige, durchgehende Metallisierung der kathodenseitigen Oberfläche des Halbleitersubstrats an. Diese Metallisierung wird bevorzugt durch das Aufsputtern von Al oder Ni realisiert. Bei Bedarf kann diese erste Metallisierungsschicht 12 (Fig. 5C) galvanisch verstärkt werden. Diese galvanische Verstärkung kann sogar soweit gehen, dass die Gategräben 9 vollständig mit Metall aufgefüllt sind.

Die durchgehende erste Metallisierungsschicht 12 muss nun an den geeigneten Stellen unterbrochen werden, um Kathoden- und Gatekontakte voneinander zu trennen. Zu diesem Zweck wird, wie in Fig. 5C dargestellt, eine Aetzmaske 11 aus Photolack aufgebracht, deren Fenster jeweils zwischen den Rändern der benachbarten Gategräben und den späteren Kathodenkontakten 6 (Fig. 5D) angeordnet sind. Durch die Fenster hindurch wird die erste Metallisierungsschicht 12 an den dortigen Stellen weggeätzt. Die Oberfläche der Struktur wird dann unter Aussparung der Kathodenkontakte 6 mit einer isolierenden Passivierungsschicht 7 (Fig. 5D) bedeckt. Zum in Fig. 5D gezeigten Endstadium des Verfahrens gelangt man, in dem über der Passivierungsschicht 7 und den Kathodenkontakten 6 eine zweite Metallisierungsschicht 13 in der sogenannten "overlay"-Technik aufgebracht wird. Diese zweite Metallisierungsschicht 13, die z.B. aus einer Schichtfolge Cr/Ni/Au-Metall bestehen kann, ist von der ersten Metallisierungsschicht (12 in Fig. 5C), die nunmehr in die Kathodenkontakte 6 und die Gatekontakte 3 zerfallen ist, durch die dazwischenliegende Passivierungsschicht 7 ausserhalb der Kathodenkontakte 6 elektrisch isoliert. Die Schicht 13 ist jedoch mit den Kathodenkontakten 6 leitend verbunden und schafft so die Möglichkeit einer flächigen Kathodenkontaktierung.

Die Passivierungsschicht 7 besteht vorzugsweise aus einem Polyimid oder einem anorganischen Dielektrikum (z.B. SiO₂), das durch ein Niedertemperatur-CVD-Verfahren aufgebracht werden kann.

Eine weitere, bevorzugte Variante des Herstellungsverfahrens umfasst die folgenden Schritte:
- das vordiffundierte Halbleitersubstrat 1 wird zunächst auf der Oberseite oxydiert;
- in der entstandenen SiO₂-Schicht werden die Fenster über den späteren Gategräben 9 geöffnet;
- die Gategräben bzw. -schlitze werden herausgeätzt (nasschemisch durch die bereits erwähnte KOH-Lösung);
- für die Bildung der Gatebereiche 2 wird Bor eindiffundiert;
- das Substrat wird bis auf die Gebiete der späteren Kathodenkontakte 6 mit Photolack maskiert;
- die Oxydschicht wird in den nicht-maskierten Gebieten weggeätzt; und
- die Kathodenbereiche 4 werden gebildet (z.B. durch Implantation von Phosphor).

Bei dieser Variante sind also gegenüber dem vorher beschriebenen Verfahren insbesondere die Schritte der Grabenätzung und der Bildung der Kathodenbereiche in der Reihenfolge vertauscht.

Das nach diesen Verfahren hergestellte, neuartige Bauelement unterscheidet sich von dem herkömmlichen vor allem in der kathodenseitigen Topologie. Um diese Unterschiede noch einmal besonders deutlich werden zu lassen sind das herkömmliche (Fig. 6A) und das neuartige (Fig. 6B) Bauelement in perspektivischer Ansicht noch einmal in den Fig. 6A und 6B einander gegenübergestellt.

In Fig. 6A ist dabei von der GTO-Version ausgegangen worden, die einen Anodenkontakt 14, eine p-dotierte Anodenschicht 15, eine n-Basisschicht16 und eine p-Basisschicht 17 im Halbleitersubstrat 1 aufweist.

In Fig. 6B sind dagegen die Einzelkeiten bezüglich der verschiedenen Schichten, insbesondere in der Steuerzone (Kathodenfinger 18 und Gategräben 9) weggelassen worden, um nicht die Uebersichtlichkeit der Darstellung einzubüssen.

Im Vergleich beider Ansichten wird die Quasi-Planarität des neuartigen Bauelements gegenüber der Zwei-Ebenen-Struktur des herkömmlichen Bauelements augenfällig.

Insgesamt steht mit der Erfindung ein neuartiges Bauelement zur Verfügung, dass sich durch bessere Flächenausnutzung, vereinfachten Randabschluss, Möglichkeiten zur Integration weiterer Bauelemente im Randbereich, höhere mechanische Festigkeit sowie leichtere Herstellbarkeit auszeichnet.

## Patentansprüche

1. Halbleiterbauelement, insbesondere für hohe Leistungen, welches Bauelement über eine Gateelektrode abschaltbar ist, umfassend
(a) ein einkristallines, mit seiner Oberfläche in (110)-Kristallrichtung orientiertes Halbleitersubstrat (1) aus Si, welches zwischen einer Anode und einer Kathode eine Mehrzahl unterschiedlich dotierter Schichten aufweist;
(b) auf der Kathodenseite eine als Gate wirkenden Steuerzone mit einer Mehrzahl von streifenförmigen Kathodenfingern (18), welche
(c) durch zwischen den Kathodenfingern (18) angeordnete, in das Halbleitersubstrat eingelassene Gategräben (9) voneinander getrennt sind, wobei
(d) in den Gategräben (9) Gatekontakte (3) zur Steuerung des Bauelements vorgesehen sind;
dadurch gekennzeichnet, dass
(e) die Gategräben (9) als schmale tiefe Schlitze entlang der (111)-Kristallrichtung ausgeführt sind;
(f) die Gategräben (9) sich in ihrer Ausdehnung auf den Bereich zwischen den Kathodenfingern (18) beschränken; und
(g) ausserhalb der Kathodenfinger (18) die ursprüngliche, kathodenseitige Substratoberfläche (8) des Halbleitersubstrats (1) erhalten bleibt.

2. Halbeiterbauelement nach Anspruch 1, dadurch gekennzeichnet, dass
(a) das Halbleitersubstrat (1) im bereich der Gatagräben (9) aus einkristallinem Silizium besteht;
(b) die Substratoberfläche (8) in der (110)-Kristallrichtung orientiert ist; und
(c) die Gategräben (9) im wesentlichen entlang der (111)-Kristallrichtung verlaufen.

3. Halbleiterbauelement nach Anspruch 1, dadurch gekennzeichnet, dass
(a) in die Oberseiten der Kathodenfinger (18) n⁺-dotierte Kathodenbereiche (4) eingebracht sind;
(b) die Gategräben (9) am Boden und in den Seitenwänden jeweils von einem in das Halbleitersubstrat (1) eingebrachten, p-dotierten Gatebereich (2) umgeben sind;
(c) die Gategräben (9) auf dem Boden und an den Seitenwänden durchgehend mit einem metallischen Gatekontakt (3) bedeckt sind;
(d) über den Kathodenbereichen (4) jeweils metallische Kathodenkontakte (6) angeordnet und von den Gatekontakten (3) der benachbarten Gategräben (9) durch entsprechende Isolierschichten (5) getrennt sind;
(e) auf der Kathodenseite die Bereiche ausserhalb der Kathodenkontakte (6) durch eine Passivierungsschicht (7) abgedeckt sind; und
(f) über der Passivierungsschicht (7) zur kathodenseitigen Kontaktierung eine Metallisierungsschicht (13) vorgesehen ist, welche mit den Kathodenkontakten (6) in leitender Verbindung steht.

4. Halbleiterbauelement nach Anspruch 3, dadurch gekennzeichnet, dass die Gategräben vollständig mit Metall, vorzugsweise Ni, aufgefüllt sind, und für die Passivierungsschicht (7) ein Polyimid oder ein anorganisches Dielektrikum verwendet wird.

5. Halbleiterbauelement nach Anspruch 3, dadurch gekennzeichnet, dass
(a) das Bauelement die Schichtstruktur eines Feldgesteuerten Thyristors (FCTh = Field Controlled Thyristors) mit einer anodenseitigen p-dotierten Anodenschicht und einer n⁻-dotierten, in die Kathodenfinger (18) hineinreichenden Kanalschicht aufweist;
(b) der in jedem Kathodenfinger (18) gebildete Kanal ein Verhältnis von Tiefe (T) zu Breite (B) im Bereich von 0,5 bis 10, vorzugsweise etwa 1 bis 2, aufweist, wobei die Kathodenfinger (18) selbst zwischen 5 und 500 µm, vorzugsweise etwa 20 µm, breit sind; und
(c) die Gategräben (9) zwischen 5 und 500 µm, vorzugsweise etwa 10 µm, breit sind.

6. Halbleiterbauelement nach Anspruch 3, dadurch gekennzeichnet, dass
(a) das Bauelement die Schichtstruktur eines über das Gate abschaltbaren Thyristors (GTO = Gate Turn Off) mit einer anodenseitigen, p-dotierten Anodenschicht, einer n-dotierten n-Basisschicht und einer p-dotierten, in die Kathodenfinger (18) hineinreichenden p-Basisschicht aufweist;
(b) die Tiefe der Gategräben (9) grösser als 5 um, jedoch kleiner als die Tiefe der p-Basisschicht, vorzugsweise etwa 20 µm, ist;
(c) die Breite der Gategräben (9) zwischen 5 und 500 µm, vorzugsweise etwa 10 µm, beträgt; und
(d) die Kathodenfinger (18) zwischen 5 und 500 µm, vorzugsweise etwa 50 µm, breit sind.

7. Verfahren zur Herstellung eines Halbleiterbauelements nach Anspruch 1, gekennzeichnet durch die folgenden Schritte:
(a) Es wird eine einkristallines, mit seiner Oberfläche in (110)-Kristallrichtung orientiertes Halbleiter substrat (1) aus Si verwendet;
(b) die kathodenseitige, planare Oberfläche des entsprechend der späteren Schichtenfolge dotierten Halbleitersubstrats (1) wird ganzflächig mit einer Maskenschicht, vorzugsweise aus SiO₂, abgedeckt;
(c) die Maskenschicht wird selektiv in den Gebieten der späteren Kathodenkontakte (6) durch Aetzen entfernt;
(d) durch die ausgeätzten Fenster in der Maskenschicht werden n⁺-dotierte Kathodenbereiche (4) in das Halbleitersubstrat (1) eingebracht;
(e) die Maskenschicht und ihre Fenster werden bis auf die Gebiete der späteren Gategräben (9) mit einer ätzresistenten Maske, vorzugsweise aus Al oder SiO₂, abgedeckt; und
(f) in den nichtabgedeckten Gebieten werden durch einen anisotropen Aetzprozess mittels einer erwärmten KOH-Lösung zuerst die Maskenschicht entfernt und dann die Gategräben (9) in Form tiefer, schmaler Schlitze zwischen den Kathodenbereichen (4) entlang der (111)-Kristallrichtung aus dem Halbleitersubstrat (1) ausgeätzt.

8. Verfahren nach Anspruch 7, dadurch gekennzeichnet, dass
(a) nach dem Ausätzen der Gategräben (9) die ätzresistente Maske entfernt und nach dem Einbringen der Gatebereiche (2) das Halbleitersubstrat (1) auf seiner kathodenseitigen Oberfläche, einschliesslich der Gategräben (9), durchgehend metallisiert wird, insbesondere durch Aufsputtern von Al oder Ni;
(b) diese erste Metallisierungsschicht (12) auf den Kathodenfingern (18) zwischen den Rändern der benachbarten Gategräben (9) und den späteren Kathodenkontakten (6) durch Wegätzen unterbrochen wird, wobei die übrigen Teile der ersten Metallisierungsschicht (12) als Gatekontakte (3) und Kathodenkontakte (6) stehenbleiben;
(c) die kathodenseitige Oberfläche des Halbleitersubstrats (1) einschliesslich der Gategräben (9) unter Aussparung der Kathodenkontakte (6) mit einer isolierenden Passivierungsschicht (7) bedeckt wird, welche vorzugsweise durch Auftragen eines Polyimids oder durch Niedertemperatur-Abscheidung eines anorganischen Dielektrikums aus der Dampfphase (CVD = Chemical Vapor Deposition) erzeugt wird; und
(d) über der Passivierungsschicht (7) und den Kathodenkontakten (6) eine zweite Metallisierungsschicht (13) in overlay-Technik aufgebracht wird.

9. Verfahren zur Herstellung eines Halbleiterbauelements nach Anspruch 1, gekennzeichnet durch die folgenden Schritte:
(a) Es wird eine einkristallines, mit seiner Oberfläche in (110)-Kristallrichtung orientiertes Halbleiter substrat (1) aus Si verwendet;
(b) die kathodenseitige, planare Oberfläche des entsprechend der späteren Schichtenfolge dotierten Halbleitersubstrats (1) wird ganzflächig mit einer Maskenschicht aus SiO₂ bedeckt;
(c) die Maskenschicht wird selektiv in den Gebieten der späteren Gategraben (9) durch Aetzen entfernt;
(d) in den nichtabgedeckten Gebieten werden durch einen nasschemischen, anisotropen Aetzprozess mittels einer erwärmten KOH-Lösung die Gategräben (9) in Form tiefer, schmaler Schlitze aus dem Halbleitersubstrat (1) entlang der (111)-Kristallrichtung herausgeätzt;
(e) in den Gategräben (9) werden durch Eindiffundieren von Bor Gatebereiche (2) erzeugt;
(f) das Halbleitersubstrat (1) wird bis auf die Gebiete der späteren Kathodenkontakte (6) mit einem Photolack abgedeckt;
(g) in den nichtabgedeckten Gebieten wird die SiO₂-Maskenschicht weggeätzt; und
(h) durch Implantation, vorzugsweise von Phosphor, werden n⁺-dotierte Kathodenbereiche (4) in das Halbleitersubstrat (1) eingebracht.

## Claims

1. Semiconductor component, particularly for high powers, which component can be turned off via a gate electrode, comprising
(a) a monocrystalline semiconductor substrate (1) of Si which is oriented with its surface in (110) crystal direction and which has a plurality of differently doped layers between an anode and a cathode;
(b) on the cathode side, a control zone, acting as gate, with a plurality of strip-shaped cathode fingers (18) which
(c) are separated from each other by gate trenches (9) arranged between the cathode fingers (18) and inserted into the semiconductor substrate,
(d) gate contacts (3) for controlling the component being provided in the gate trenches (9);
characterised in that
(e) the gate trenches (9) are constructed as narrow deep slots along crystal direction (111);
(f) the gate trenches (9) are limited in their extent to the region between the cathode fingers (18); and
(g) the original cathode-side substrate surface (8) of the semiconductor substrate (1) is retained outside the cathode fingers (18).

2. Semiconductor component according to Claim 1, characterised in that
(a) the semiconductor substrate (1) consists of monocrystalline silicon in the region of the gate trenches (9);
(b) the substrate surface (8) is oriented in crystal direction (110); and
(c) the gate trenches (9) essentially extend along crystal direction (111).

3. Semiconductor component according to Claim 1, characterised in that
(a) n⁺-doped cathode regions (4) are inserted into the tops of the cathode fingers (18);
(b) the gate trenches (9) are in each case surrounded at the bottom and in the side walls by a p-doped gate region (2) inserted into the semiconductor substrate (1);
(c) the gate trenches (9) are continuously covered at the bottom and at the side walls with a metallic gate contact (3);
(d) metallic cathode contacts (6) are in each case arranged above the cathode regions (4) and are separated from the gate contacts (3) of the adjacent gate trenches (9) by corresponding insulating layers (5);
(e) the areas outside the cathode contacts (6) on the cathode side are covered by a passivation layer (7); and
(f) a metallisation layer (13), which is conductively connected to the cathode contacts (6), is provided above the passivation layer (7) for cathode-side contact.

4. Semiconductor component according to Claim 3, characterised in that the gate trenches are completely filled with metal, preferably Ni, and a polyimide or an inorganic dielectric is used for the passivation layer (7).

5. Semiconductor component according to Claim 3, characterised in that
(a) the component has the layer structure of a field-controlled thyristor (FCTh = Field Controlled Thyristor) with an anode-side p-doped anode layer and an n⁻-doped channel layer projecting into the cathode fingers (18);
(b) the channel formed in each cathode finger (18) has a ratio of depth (T) to width (B) within a range of 0.5 to 10, preferably about 1 to 2, the cathode fingers (18) themselves having a width of between 5 and 500 µm, preferably about 20 µm; and
(c) the gate trenches (9) have a width of between 5 and 500 µm, preferably about 10 µm.

6. Semiconductor component according to Claim 3, characterised in that
(a) the component has the layer structure of a thyristor which can be turned off via its gate (GTO = Gate Turn Off) having an anode-side p-doped anode layer, an n-doped n base layer and a p-doped p base layer extending into the cathode fingers (18);
(b) the depth of the gate trenches (9) is greater than 5 µm but less than the depth of the p base layer, preferably about 20 µm;
(c) the width of the gate trenches (9) is between 5 and 500 µm, preferably about 10 µm; and
(d) the cathode fingers (18) have a width of between 5 and 500 µm, preferably about 50 µm.

7. Method for producing a semiconductor component according to Claim 1, characterised by the following steps:
(a) a monocrystalline semiconductor substrate (1) of Si oriented with its surface in crystal direction (110) is used;
(b) the cathode-side planar surface of the semiconductor substrate (1) doped in accordance with the later sequence of layers is covered over its whole area with a mask layer, preferably of SiO₂;
(c) the mask layer is selectively removed by etching in the regions of the later cathode contacts (6);
(d) n⁺-doped cathode regions (4) are inserted into the semiconductor substrate (1) through the etched-out windows in the mask layer,
(e) the mask layer and its windows are covered with an etching-resistant mask, preferably of aluminium or SiO₂, except for the regions of the later gate trenches (9); and
(f) in the regions which are not covered, first the mask layer is removed by means of a warmed KOH solution by an anisotropic etching process and then the gate trenches (9) are etched out of the semiconductor substrate (1) in the form of deep narrow slots between the cathode regions (4) along the crystal direction (111).

8. Method according to Claim 7, characterised in that
(a) the etching-resistant mask is removed after the gate trenches (9) have been etched out, and, after the gate regions (2) have been inserted, the semiconductor substrate (1) is continuously metallised on its cathode-side surface, including the gate trenches (9), in particular by spattering on aluminium or nickel;
(b) this first metallisation layer (12) is interrupted by being etched away on the cathode fingers (18) between the edges of the adjacent gate trenches (9) and the later cathode contacts (6), the other parts of the first metallisation layer (12) remaining as gate contacts (3) and cathode contacts (6);
(c) the cathode-side surface of the semiconductor substrate (1), including the gate trenches (9) is covered, omitting the cathode contacts (6), with an insulating passivation layer (7) which is preferably generated by applying a polyimide or low-temperature separation of an anorganic dielectric from the vapour phase (CVD = Chemical Vapour Deposition); and
(d) a second metallisation layer (13) is applied above the passivation layer (7) and the cathode contacts (6) by the overlay technique.

9. Method for producing a semiconductor component according to Claim 1, characterised by the following steps:
(a) a monocrystalline semiconductor substrate (1) of Si oriented with its surface in crystal direction (110) is used;
(b) the cathode-side planar surface of the semiconductor substrate (1) doped in accordance with the later sequence of layers is covered over its whose area with a mask layer of SiO₂;
(c) the mask layer is selectively removed by etching in the regions of the later gate trenches (9);
(d) in the regions which are not covered, the gate trenches (9) are etched out of the semiconductor substrate (1) along the crystal direction in the form of deep narrow slots by means of a warmed KOH solution by means of a wet chemical anisotropic etching process;
(e) gate regions (2) are generated in the gate trenches (9) by diffusing in boron;
(f) the semiconductor substrate (1), except for the regions of the later cathode contacts (6), is covered with a photoresist;
(g) the SiO₂ mask layer is etched away in the regions not covered; and
(h) n⁺-doped cathode regions (4) are inserted into the semiconductor substrate (1) by implantation, preferably of phosphorus.

## Revendications

1. Composant semi-conducteur, en particulier pour de fortes puissances, qui peut être déclenché par l'intermédiaire d'une électrode de gâchette, comprenant :
(a) un substrat semi-conducteur (1) monocristallin en Si, orienté par sa surface dans la direction cristalline (110), qui comporte une pluralité de couches à dopages différents entre une anode et une cathode;
(b) du côté cathodique, une zone de commande fonctionnant comme une gâchette, comportant une pluralité de doigts de cathode en forme de bandes (18), qui
(c) sont séparés les uns des autres par des fosses de gâchette (9) disposées entre les doigts de cathode (18) et s'enfonçant dans le substrat semi-conducteur,
(d) des contacts de gâchette (3) pour la commande du composant étant prévus dans les fosses de gâchette (9),
caractérisé en ce que
(e) les fosses de gâchette (9) ont la forme de fentes profondes et étroites le long de la direction cristalline (111);
(f) les fosses de gâchette (9) étant limitées dans leur étendue au domaine situé entre les doigts de cathode (18) et,
(g) à l'extérieur des doigts de cathode (18), la surface initiale (8), du côté cathodique, du substrat semi-conducteur (1), restant maintenue.

2. Composant semi-conducteur suivant la revendication 1, caractérisé en ce que
(a) le substrat semi-conducteur (1) est en silicium monocristallin dans le domaine des fosses de gâchette (9);
(b) la surface de substrat (8) est orientée dans la direction cristalline (110), et
(c) les fosses de gâchette (9) s'étendent en substance le long de la direction cristalline (111).

3. Composant semi-conducteur suivant la revendication 1, caractérisé en ce que
(a) des domaines de cathode à dopage n⁺ (4) sont établis dans les faces supérieures des doigts de cathode (18);
(b) les fosses de gâchette (9) sont entourées, au fond et dans les parois latérales, chacune par un domaine de gâchette (2) à dopage p établi dans le substrat semi-conducteur (1);
(c) les fosses de gâchette (9) sont recouvertes, sur le fond et sur les parois latérales, d'une manière continue par un contact de gâchette métallique (3);
(d) sur les domaines de cathode (4) sont disposés respectivement des contacts de cathode métalliques (6) qui sont séparés des contacts de gâchette (3) des fosses de gâchette (9) voisines par des couches isolantes (5) correspondantes;
(e) du côté cathodique, les domaines situés à l'extérieur des contacts de cathode (6) sont recouverts par une couche de passivation (7), et
(f) sur la couche de passivation (7), est prévue, en vue de la mise en contact du côté cathodique, une couche de métallisation (13) qui est en liaison conductrice avec les contacts de cathode (6).

4. Composant semi-conducteur suivant la revendication 3, caractérisé en ce que les fosses de gâchette sont remplies complètement de métal, de préférence du Ni, et un polyimide ou un diélectrique inorganique est utilisé pour la couche de passivation (7).

5. Composant semi-conducteur suivant la revendication 3, caractérisé en ce que
(a) le composant présente la structure en couches d'un thyristor commandé par le champ (FCTh = Field Controlled Thyristors) comportant une couche d'anode à dopage p du côté anodique et une couche de canal à dopage n⁻ qui s'étend dans les doigts de cathode (18);
(b) le canal formé dans chaque doigt de cathode (18) présente un rapport de la profondeur (T) à la largeur (B) compris entre 0,5 et 10, de préférence d'environ 1 à 2, les doigts de cathode (18) eux-mêmes étant d'une largeur comprise entre 5 et 500 µm, de préférence d'environ 20 µm, et
(c) les fosses de gâchette (9) sont d'une largeur comprise entre 5 et 500 µm, de préférence d'environ 10 µm.

6. Composant semi-conducteur suivant la revendication 3, caractérisé en ce que
(a) le composant présente la structure en couches d'un thyristor déclenchable par la gâchette (GTO = Gate Turn Off) comportant une couche d'anode à dopage p du côté anodique, une couche de base n à dopage n et une couche de base p à dopage p qui s'étend dans les doigts de cathode (18);
(b) la profondeur des fosses de gâchette (9) est supérieure a 5 µm, mais est inférieure à la profondeur de la couche de base p, sa valeur préférée étant d'environ 20 µm;
(c) la largeur des fosses de gâchette (9) est comprise entre 5 et 500 µm, sa valeur préférée étant d'environ 10 µm, et
(d) les doigts de cathode (18) sont d'une largeur comprise entre 5 et 500 µm, leur valeur préférence étant d'environ 50 µm.

7. Procédé de fabrication d'un composant semi-conducteur suivant la revendication 1, caractérisé par les opérations suivantes :
(a) on utilise un substrat monocristallin (1) en Si dont la surface est orientée dans la direction cristalline (110);
(b) la surface plane du côté cathodique du substrat semi-conducteur (1) dopé correspondant à la succession de couches ultérieures est recouverte sur toute son étendue d'une couche de masquage, de préférence en SiO₂;
(c) la couche de masquage est éliminée sélectivement par attaque chimique dans les régions des contacts de cathode ultérieurs (6);
(d) des domaines de cathode à dopage n⁺ (4) sont établis dans le substrat semi-conducteur (1) dans la couche de masquage formée par attaque chimique;
(e) la couche de masquage et ses fenêtres sont recouvertes jusqu'aux régions des fosses de gâchette (9) ultérieures d'un masque résistant à l'attaque chimique, de préférence en Al ou en SiO₂, et
(f) dans les régions non recouvertes, la couche de masquage est tout d'abord éliminée par un processus d'attaque chimique anisotrope au moyen d'une solution de KOH réchauffée, puis les fosses de gâchette (9) sont formées par attaque chimique dans le substrat semi-conducteur (1), sous la forme de fentes étroites et profondes, entre les domaines de cathode (4) et le long de la direction cristalline (111).

8. Procédé suivant la revendication 7, caractérisé en ce que
(a) après la formation par attaque chimique des fosses de gâchette (9), le masque résistant à l'attaque chimique est éliminé et après l'établissement des domaines de gâchette (2), le substrat semi-conducteur (1) est métallisé de manière continue sur sa surface du côté cathodique y compris les fosses de gâchette (9), en particulier par pulvérisation de Al ou de Ni;
(b) cette première couche de métallisation (12) est interrompue par attaque chimique sur les doigts de cathode (18) entre les bords des fosses de gâchette (9) voisines et les contacts de cathode (6) ultérieurs, les parties restantes de la première couche de métallisation (12) subsistant en tant que contacts de gâchette (3) et que contacts de cathode (6);
(c) la surface du côté cathodique du substrat semi-conducteur (1), y compris les fosses de gâchette (9), à l'exclusion des contacts de cathode (6), est recouverte d'une couche de passivation isolante (7) qui est produite par application d'un polyimide ou par dépôt à basse température d'un diélectrique inorganique en phase vapeur (CVD = Chemical Vapor Deposition), et
(d) une seconde couche de métallisation (13) est appliquée suivant la technique overlay sur la couche de passivation (7) et les contacts de cathode (b).

9. Procédé de fabrication d'un composant semi-conducteur suivant la revendication 1, caractérisé par les opérations suivantes :
(a) on utilise un substrat semi-conducteur (1) monocristallin en Si dont la surface est orientée dans la direction cristalline (110);
(b) la surface plane du côté cathodique du substrat semi-conducteur (1) dopé d'une manière correspondant à l'ordre ultérieur des couches est recouverte sur toute son étendue d'une couche de masquage en SiO₂;
(c) la couche de masquage est éliminée sélectivement par attaque chimique dans les régions des fosses de gâchette ultérieures (9);
(d) dans les régions non recouvertes, les fosses de gâchette (9) sont formées par attaque chimique par un procédé d'attaque à l'acide anisotrope au moyen d'une solution de KOH réchauffée, sous la forme de fentes étroites et profondes dans le substrat semi-conducteur (1) le long de la direction cristalline (111);
(e) dans les fosses de gâchette (9), des domaines de gâchette (2) sont produits par diffusion de bore;
(f) le substrat semi-conducteur (1) est recouvert jusqu'aux régions des contacts de cathode (6) ultérieures au moyen d'un vernis photosensible;
(g) la couche de masquage en SiO₂ est éliminée par attaque chimique dans les régions non recouvertes, et
(h) par implantation, de préférence de phosphore, les domaines de cathode à dopage n⁺ (4) sont établis dans le substrat semi-conducteur (1).
